# DEMANDE DE BREVET EUROPEEN

(11) **EP 1 233 419 A2**
(43) Date de publication de la demande: **21.08.2002**
(21) Numéro de dépôt: 02075562.5
(22) Date de dépôt: 11.02.2002
(51) Int. Cl.: G11C 11/406

(54) **Procédé de rafraîchissement d'une mémoire dynamique**

(30) Priorité: 16.02.2001 FR 0102136
(71) Demandeur: Koninklijke Philips Electronics N.V., 5621 BA Eindhoven (NL)
(72) Inventeur: Duranton, Marc, Société Civile S.P.I.D, 75008 Paris (FR)
(74) Mandataire: Chaffraix, Jean

(57) **Abrégé**

Un procédé de rafraîchissement d'une mémoire dynamique destinée à stocker des variables intervenant dans des opérations effectuées par un processeur comprend une étape d'ordonnancement 10 au cours de laquelle sont établis un ordre et un chronométrage des opérations, une étape d'estimation 13 d'un temps de rétention propre à chaque variable, une étape de prévision 14 d'au moins un instant auquel chaque variable doit être rafraîchie, une étape de placement 15 au cours de laquelle les variables sont placées dans la mémoire et une étape de rafraîchissement 16 au cours de laquelle les variables sont rafraîchies aux instants définis pendant l'étape de prévision 14. L'invention permet une réduction des temps de latence et de la consommation de courant liés au rafraîchissement. Elle présente notamment un intérêt dans des systèmes où la contrainte temps réel est importante, par exemple des systèmes de traitement de données vidéo.

## Description

### DOMAINE TECHNIQUE

L'invention concerne un procédé de rafraîchissement d'une mémoire dynamique destinée à stocker des variables intervenant dans des opérations effectuées par un processeur.
L'invention concerne également un équipement comprenant des moyens de stockage et de traitement de données, dont notamment des moyens de mise en oeuvre d'un tel procédé.
L'invention trouve son application, par exemple, dans un système programmable dédié à une application avec des contraintes de type temps réel, tel un système de traitement de données vidéo.

### ETAT DE LA TECHNIQUE ANTERIEURE

Dans des circuits intégrés, le traitement de signaux nécessite de plus en plus de capacité de stockage. Pour augmenter cette capacité de stockage, des mémoires embarquées sont souvent utilisées. Il existe deux types de telles mémoires :
- des mémoires statiques, comme des mémoires statiques à accès aléatoire (en anglais SRAM).
- des mémoires dynamiques, comme des mémoires dynamiques à accès aléatoire (en anglais DRAM).
Les mémoires statiques sont construites à partir de bascules. Lorsqu'une donnée est stockée dans une mémoire statique, cette donnée reste stockée aussi longtemps que le circuit contenant la mémoire statique est alimenté. Les mémoires dynamiques stockent les données sous la forme de charge de capacités. Du fait de courants de fuite occasionnant des pertes de charge, il est nécessaire de recharger fréquemment ces capacités afin de garder les données en mémoire. Cette opération s'appelle le rafraîchissement d'une donnée, et doit être effectuée, suivant les mémoires utilisées, toutes les 1 à 10 millisecondes environ. La durée pendant laquelle une donnée peut être gardée en mémoire sans que cela ne nécessite de rafraîchissement est appelée 'temps de rétention', qui est propre à la donnée considérée. Cependant, les mémoires dynamiques sont utilisées du fait de leur grande capacité de stockage. En effet, pour stocker un bit de donnée, une mémoire dynamique nécessite un seul transistor alors qu'une mémoire statique en nécessite 4 à 6. Pour une même capacité de stockage, une mémoire dynamique apparaît ainsi moins coûteuse qu'une mémoire statique. Mais le rafraîchissement des données nécessaire à la mémoire dynamique introduit un temps de latence non négligeable, pendant lequel un processeur ne peut pas avoir accès aux données stockées dans ladite mémoire. En effet, le rafraîchissement s'effectue de manière systématique sur l'ensemble des données contenues dans la mémoire dynamique, ce qui nécessite un temps considérable. Le brevet US 5148546 a notamment pour but de remédier à cet inconvénient, en proposant un procédé permettant de déterminer de façon dynamique les adresses mémoire des données à rafraîchir, afin de ne rafraîchir à un instant donné que les données nécessitant un rafraîchissement. Ainsi à cet instant donné, un grand nombre de données est accessible au processeur, car ces données ne sont pas monopolisées par le circuit de rafraîchissement, et il en résulte, en moyenne dans le temps, une diminution du temps de latence. Cependant, ce procédé nécessite l'implantation d'un sous-système dans le circuit, afin de déterminer les adresses mémoire des données à rafraîchir. En outre, ce procédé ne permet pas une grande diminution du temps de latence, car la détermination dynamique des adresses mémoire des données à rafraîchir nécessite elle aussi un certain temps.

### EXPOSE DE L'INVENTION

Un but de l'invention est de proposer un procédé permettant de diminuer le temps de latence dû au rafraîchissement dans une mémoire dynamique.

Selon l'invention, un procédé de rafraîchissement d'une mémoire dynamique tel que défini dans le paragraphe d'ouverture est caractérisé en ce qu'il comprend :
- une étape d'ordonnancement au cours de laquelle sont établis un ordre et un chronométrage desdites opérations ;
- une étape d'estimation d'un temps de rétention propre à chaque variable ;
- une étape de prévision d'au moins un instant auquel chaque variable doit être rafraîchie, un instant auquel une variable donnée doit être rafraîchie étant fonction du temps de rétention de ladite variable donnée et du chronométrage des opérations dans lesquelles intervient ladite variable donnée ;
- une étape de placement au cours de laquelle lesdites variables sont placées dans ladite mémoire ;
- une étape de rafraîchissement au cours de laquelle lesdites variables sont rafraîchies aux instants définis pendant l'étape de prévision.

L'invention tire parti du fait que dans certains systèmes programmables, il est possible de connaître, au moment d'une compilation d'un programme définissant les opérations à effectuer par le processeur, l'ordre de ces opérations, le chronométrage de ces opérations ainsi que les variables mises en jeu dans ces opérations. De plus, le temps de rétention propre à une variable étant lié à la technologie utilisée pour la fabrication de la mémoire dynamique, l'estimation de ce temps de rétention ne présente pas de difficultés. Ainsi, connaissant l'instant où une variable est créée, l'instant où cette variable est utilisée dans une opération et le temps de rétention de cette variable, il est possible de prévoir à quel instant cette variable doit être rafraîchie. Par ailleurs, en plaçant les variables judicieusement dans la mémoire, de sorte que les variables devant être rafraîchies au même instant se trouvent, par exemple, dans une même zone de la mémoire, il est possible de réduire le temps de latence dû au rafraîchissement de la mémoire dynamique. En outre, le rafraîchissement d'une variable pouvant être effectué par une lecture de cette variable par le processeur, ce procédé ne nécessite pas d'ajout de circuit de rafraîchissement : le processeur est apte à gérer seul le rafraîchissement de la mémoire dynamique.

Dans la mesure où les étapes décrites ci-dessus peuvent être effectuées par un logiciel, l'invention prévoit également un programme d'ordinateur comprenant des instructions de code de programme pour l'exécution des étapes du procédé décrit ci-dessus lorsque ledit programme est exécuté sur un ordinateur.

### BREVE DESCRIPTION DES FIGURES

L'invention sera mieux comprise et d'autres détails apparaîtront dans la description qui va suivre en regard des dessins annexés qui sont donnés à titre d'exemples non limitatifs et dans lesquels :
- la figure 1 est un diagramme bloc illustrant des caractéristiques de l'invention ;
- la figure 2 illustre un exemple d'architecture de système de communication entre une mémoire dynamique et un processeur ;
- la figure 3 illustre le principe d'une écriture et d'une lecture d'une donnée dans une mémoire dynamique ;
- les figures 4a à 4c illustrent différents types de rafraîchissement d'une mémoire dynamique selon l'art antérieur ;
- la figure 5 illustre un ordonnancement d'opérations effectuées par un processeur ainsi qu'une prévision d'instants auxquels une variable doit être rafraîchie ;
- la figure 6 illustre un exemple d'application de l'invention pour un traitement de données vidéo.

### MODE DE REALISATION DE L'INVENTION

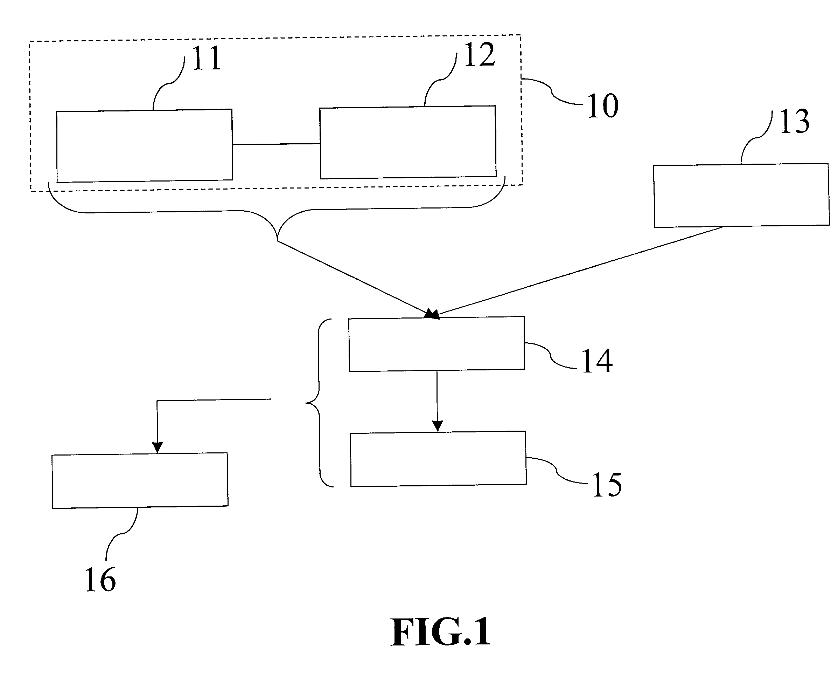

La figure 1 illustre des caractéristiques de l'invention. Un procédé de rafraîchissement d'une mémoire dynamique selon l'invention comprend une étape d'ordonnancement 10 comprenant une sous-étape de détermination 11 de l'ordre des opérations et une sous-étape de chronométrage 12, une étape d'estimation 13 du temps de rétention des variables, une étape de prévision 14 des instants auxquels les variables doivent être rafraîchies, une étape de placement 15 et une étape de rafraîchissement 16. Dans un mode de mise en oeuvre particulièrement avantageux de l'invention, les opérations à effectuer par un processeur constituent un programme ; les étapes d'ordonnancement 10, d'estimation 13 du temps de rétention des variables, de prévision 14 et de placement 15 sont effectuées par le processeur lors d'une compilation de ce programme.

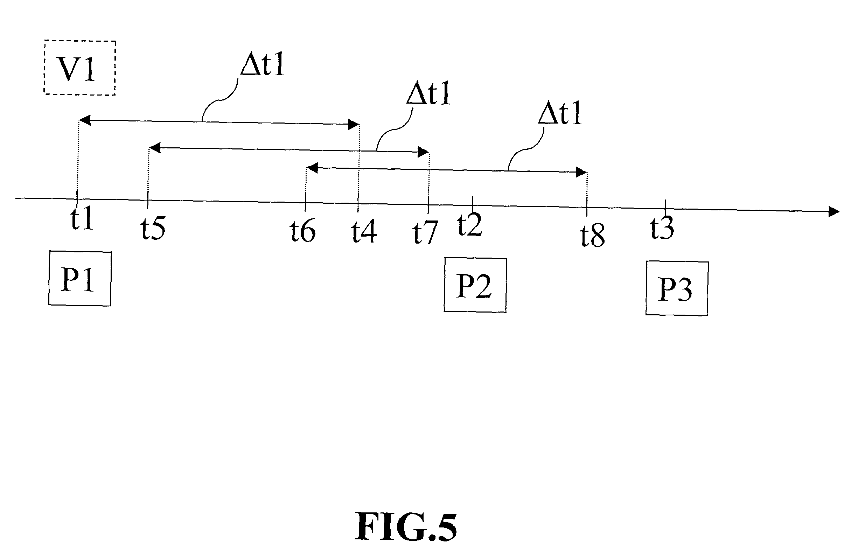

Lors de la compilation du programme, le processeur détermine, pendant la sous-étape de détermination 11 de l'ordre des opérations, toutes les opérations qui vont être effectuées par le programme, l'ordre dans lesquelles ces opérations vont être effectuées ainsi que les différentes variables intervenant dans ces opérations. Lors de la sous-étape de chronométrage 12, le processeur détermine les instants auxquels les variables vont être créées, les instants auxquels les variables vont être utilisées pour effectuer les différentes opérations et les instants à partir desquels certaines variables ne seront plus utilisées. Ces deux sous-étapes sont particulièrement faciles à mettre en oeuvre dans des systèmes programmables tels un système dédié à une application avec des contraintes de type temps réel. En effet, dans ces systèmes, toutes les opérations ainsi que leur chronométrage sont connues lors de la compilation du programme, et non de manière dynamique lors de l'exécution du programme, comme c'est le cas dans certains autres systèmes de traitement de données. L'étape d'estimation 13 du temps de rétention des variables permet de connaître la durée à partir de laquelle une donnée stockée en mémoire ne sera plus utilisable par le processeur en l'absence d'un rafraîchissement. En fonction des résultats de l'étape d'ordonnancement 10 et de l'étape d'estimation 13 du temps de rétention des variables, l'étape de prévision 14 permet de déterminer les instants auxquels les variables devront être rafraîchies. Il faut noter que l'étape de prévision 14 peut également prendre en compte des états du dispositif de rafraîchissement, ce qui sera précisé sur la figure 5. L'étape de placement 15 permet notamment de regrouper les variables devant être rafraîchies à des instants proches dans une même zone de la mémoire dynamique. Il faut noter que cette étape de placement 15 peut également être effectuée de façon différente, par exemple sans tenir compte de résultats de l'étape de prévision 14. Il est par exemple possible d'envisager de placer les variables de façon aléatoire dans la mémoire dynamique. L'avantage d'un regroupement judicieux des variables en fonction des résultats de l'étape de prévision 14 est que cela permet de réduire la durée du rafraîchissement, donc de diminuer le temps de latence. L'étape de rafraîchissement 16 permet de rafraîchir les variables aux instants définis par l'étape de prévision 14. Dans ce mode de mise en oeuvre particulièrement avantageux de l'invention, l'étape de rafraîchissement 16 est effectuée par le processeur, grâce à une lecture de la variable à rafraîchir. L'étape de rafraîchissement 16 peut également être effectuée grâce à une lecture et une écriture de la variable à rafraîchir, réalisées par le processeur, ou éventuellement grâce à un circuit de rafraîchissement externe au processeur.

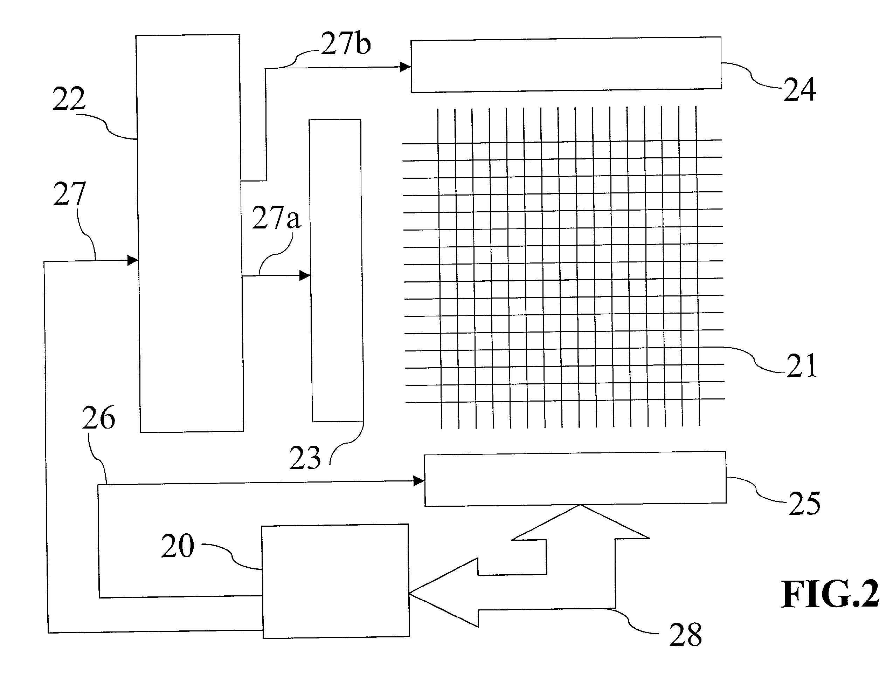

La figure 2 illustre un exemple d'architecture de système de communication entre une mémoire dynamique et un processeur. Un tel système de communication comprend un processeur 20, une mémoire dynamique 21, un multiplexeur d'adresse 22, un décodeur lignes 23, un décodeur colonnes 24 et un amplificateur de lecture et d'écriture 25. Lorsque le processeur 20 désire lire ou écrire une donnée 28 dans la mémoire dynamique 21, il envoie un signal d'adresse 27 au multiplexeur d'adresse 22 indiquant l'adresse complète dans la mémoire dynamique 21 de la donnée 28 à lire ou écrire. Un signal de commande 26 d'écriture ou de lecture généré par le processeur 20 est envoyé à l'amplificateur de lecture et d'écriture 25 afin d'indiquer si la donnée 28 doit être lue ou écrite.

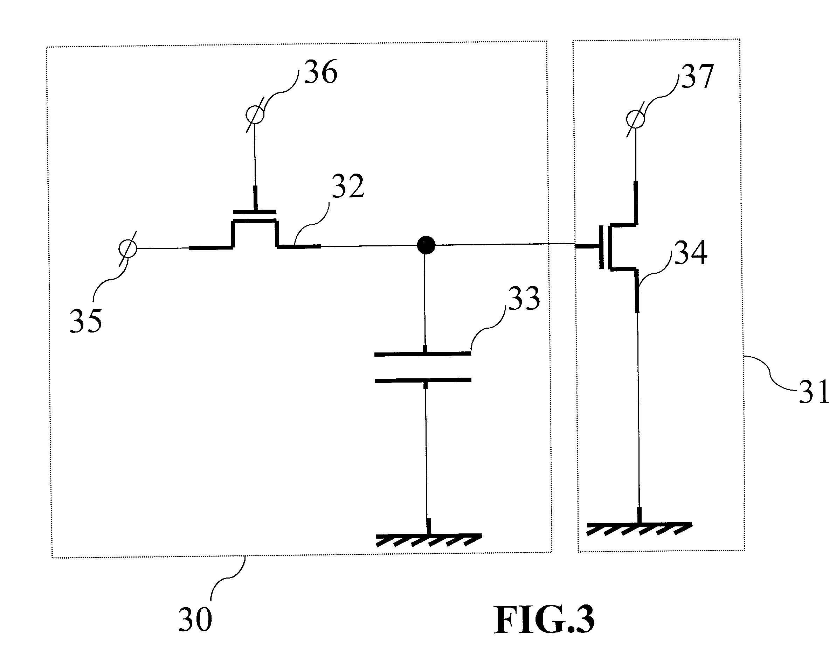

La mémoire dynamique 21 est organisée sous la forme d'une grille de L lignes et C colonnes, L et C étant des entiers, pas nécessairement égaux, de l'ordre de quelques centaines, qui sont généralement des puissances de 2. A chaque noeud de la grille, formé par une interconnexion entre une ligne et une colonne, correspond une unité de stockage d'un bit de donnée, qui sera plus précisément décrite sur la figure 3. L'ensemble constitué d'un numéro de ligne et d'un numéro de colonne constitue une adresse mémoire. Par conséquent, à une adresse mémoire correspond un bit de donnée. Lorsque le processeur 20 désire lire un bit de donnée, il envoie le signal d'adresse 27 au multiplexeur d'adresse 22. Ce signal d'adresse 27 contient le numéro de ligne et le numéro de colonne du bit de donnée considéré. Par ailleurs, le processeur 20 envoie le signal de commande 26 à l'amplificateur de lecture et d'écriture 25, indiquant que l'opération effectuée sur le bit considéré est une lecture. Le multiplexeur d'adresse 22 divise le signal d'adresse 27 en deux parties. Les bits de poids fort du signal d'adresse 27 contiennent le numéro de ligne du bit de donnée considéré, les bits de poids faible le numéro de colonne. Un signal 27a est alors envoyé au décodeur lignes 23, spécifiant le numéro de ligne du bit de donnée considéré et un signal 27b est alors envoyé au décodeur colonnes 24, spécifiant le numéro de colonne du bit de donnée considéré. Le bit de donnée considéré est alors chargé dans l'amplificateur de lecture et d'écriture 25, puis envoyé vers le processeur. Il faut noter que le fonctionnement décrit ci-dessus pourra présenter des variantes suivant le type de mémoire dynamique utilisé. En effet, il est possible de charger toute la ligne correspondant au signal 27a dans l'amplificateur de lecture et d'écriture 25, puis de sélectionner le bit de donnée considéré grâce au signal 27b. Par ailleurs, il est possible de regrouper, sur une même ligne, plusieurs bits, pour former des mots, par exemple des mots de huit bits. Pour lire un de ces mots, le processeur 20 devra spécifier dans le signal d'adresse 27 le numéro de ligne du mot considéré ainsi que l'ordre du mot sur cette ligne. Le principe de l'écriture d'un bit de donnée dans la mémoire dynamique 21 est similaire. Dans ce cas, le signal de commande 26 indique que l'opération effectuée sur le bit considéré est une écriture. Le bit de donnée considéré est chargé dans l'amplificateur de lecture et d'écriture 25, puis écrit dans la mémoire dynamique 21 à l'adresse spécifiée par le signal d'adresse 27. Il faut noter que cette description s'applique à une mémoire dynamique de type 1 bit, c'est à dire pouvant stocker un seul bit de donnée à chacun de ses noeuds. Il existe également des mémoires dynamiques pouvant stocker plusieurs bits à chacun de leurs noeuds, par exemple des mémoires dynamiques de type 4, 8 ou 16 bits. Pour ces mémoires, le principe diffère peu de celui décrit ci-dessus, une adresse mémoire correspondant à un mot de 4, 8 ou 16 bits suivant la mémoire dynamique utilisée. Dans ce cas, seuls des mots de plusieurs bits pourront être lus ou écrits par le processeur 20.

La figure 3 illustre le principe de l'écriture et de la lecture d'une donnée dans une mémoire dynamique. Une unité de stockage 30 comprend un premier transistor 32, un condensateur 33, un point d'écriture 35 et un point de sélection 36. Une unité de lecture 31 comprend un deuxième transistor 34 et un point de lecture 37. La mémoire dynamique 21 comprend une unité de stockage 30 à chacun de ses noeuds. Chaque unité de stockage 30 stocke un bit de donnée sous la forme d'une charge électrique. Elle utilise pour cela un effet capacitif propre à certains dispositifs semi-conducteurs, par exemple une capacité grille substrat du premier transistor 32. L'unité de stockage 30 est implantée sur une pastille de silicium, et une borne du premier transistor 32 est isolée de la pastille par un dépôt mince non-conducteur, ce qui forme une capacité, représentée par le condensateur 33. Ce condensateur 33 est capable d'être chargé, donc de 'mémoriser' une tension appliquée au premier transistor 32. L'état chargé ou déchargé du condensateur 33 permet de distinguer deux états, qui correspondent à deux valeurs distinctes du bit stocké dans l'unité de stockage 30, 0 ou 1. Cependant, la capacité du condensateur 33 est si faible qu'une charge ne peut y être conservée que pendant une durée limitée, appelée temps de rétention, ce qui explique la nécessité du rafraîchissement. Le fonctionnement de l'unité de stockage 30 est le suivant. Le premier transistor 32 sert d'interrupteur et est passant lorsqu'une tension est appliquée au point de sélection 36, c'est à dire lorsque l'unité de stockage 30 est sélectionnée, par exemple lorsque le processeur 20 désire écrire un bit de donné dans cette unité de stockage 30. Lorsque le processeur 20 désire écrire un bit de donnée de valeur 1 dans l'unité de stockage 30, il applique une tension au point d'écriture 35 de manière à charger le condensateur 33. Lorsque le processeur 20 désire écrire un bit de données de valeur 0 dans l'unité de stockage 30, il applique une tension au point d'écriture 35 de manière à décharger le condensateur 33. Le fonctionnement de l'unité de lecture 31 est le suivant. Lorsque le processeur 20 désire lire la donnée stockée dans l'unité de stockage 30, il mesure la tension au point de lecture 37, qui est sensiblement égale à la tension aux bornes du condensateur 33. Si cette tension correspond à l'état chargé du condensateur 33, le bit stocké dans l'unité de stockage 30 vaut 1, sinon ce bit vaut 0.

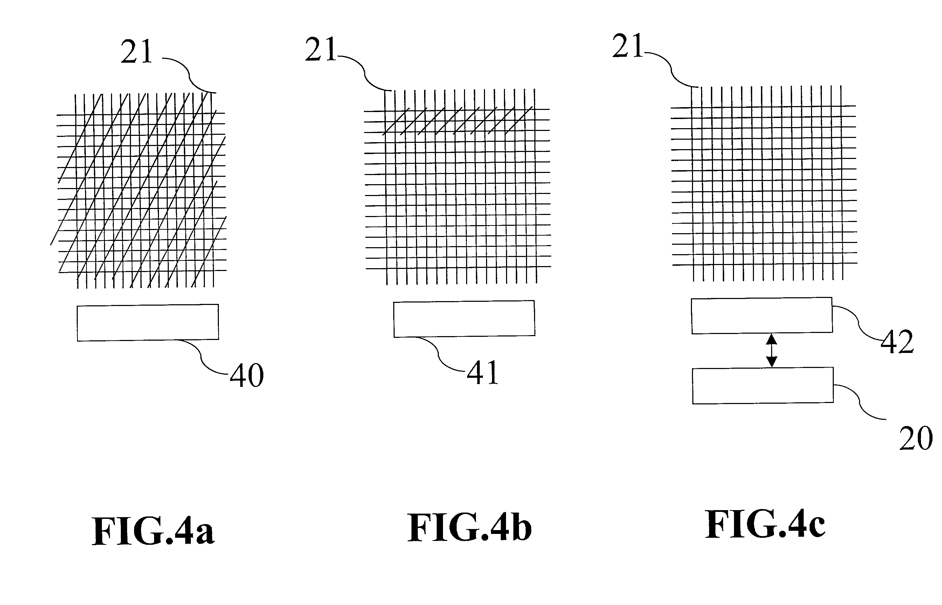

Les figures 4a à 4c illustrent différents types de rafraîchissement d'une mémoire dynamique selon l'art antérieur. La figure 4a illustre un dispositif permettant un rafraîchissement distribué. Un tel dispositif comprend la mémoire dynamique 21 et un dispositif de rafraîchissement distribué 40. Le dispositif de rafraîchissement distribué 40 effectue le rafraîchissement successif de toutes les lignes de la mémoire dynamique 21, à intervalles de temps réguliers. Pour cela, il utilise un compteur qui mesure le temps s'écoulant entre deux rafraîchissements. L'inconvénient du rafraîchissement distribué est que l'accès à la mémoire dynamique 21 par le processeur 20 n'est pas possible pendant le rafraîchissement, ce qui engendre des temps de latence importants. La figure 4b illustre un dispositif permettant un rafraîchissement de blocs. Un tel dispositif comprend la mémoire dynamique 21 et un dispositif de rafraîchissement de blocs 41. Le dispositif de rafraîchissement de blocs 41 effectue à un instant donné le rafraîchissement d'une portion de la mémoire dynamique 21, par exemple la portion hachurée sur le dessin. Là encore, pendant que cette portion de la mémoire dynamique 21 est rafraîchie, le processeur 20 n'a pas accès aux données correspondantes, et le temps de latence, même s'il est inférieur au temps de latence dû au rafraîchissement distribué, demeure important. La figure 4c illustre un dispositif permettant un rafraîchissement transparent. Un tel dispositif comprend la mémoire dynamique 21, un dispositif de rafraîchissement transparent 42 et le processeur 20. Le dispositif de rafraîchissement transparent 42 effectue le rafraîchissement de la mémoire dynamique 21 lorsque le processeur n'a pas besoin d'accéder à celle-ci. Pour qu'un tel rafraîchissement soit efficace, il faut qu'il existe suffisamment de périodes où le processeur 20 n'accède pas à la mémoire dynamique 21. Or les performances des processeurs actuels sont telles qu'ils accèdent à la mémoire dynamique 21 de façon quasi permanente, ce qui rend inefficace un tel type de rafraîchissement.

La figure 5 illustre un exemple d'ordonnancement d'opérations effectuées par le processeur 20 ainsi qu'une prévision des instants auxquels une variable doit être rafraîchie. Le processeur 20 initie un premier processus P1 à partir d'un premier instant t1, un deuxième processus P2 à partir d'un deuxième instant t2 et un troisième processus P3 à partir d'un troisième instant t3. Le premier processus P1 crée une variable V1, qui doit intervenir dans le deuxième processus P2 ainsi que dans le troisième processus P3. Le temps de rétention de la variable V1, c'est-à-dire la durée à partir de laquelle cette variable n'est plus exploitable par le processeur 20 si elle n'est pas rafraîchie, a une valeur Δt1.

En l'absence de rafraîchissement, la variable V1 n'est plus exploitable à partir d'un quatrième instant t4, tel que t4-t1=Δt1, qui précède le deuxième instant t2. Or, le deuxième processus P2 doit utiliser la variable V1 au deuxième instant t2. Il est donc nécessaire de rafraîchir la variable V1 entre le premier instant t1 et le quatrième instant t4. Le rafraîchissement s'effectuant par une lecture de la variable V1 par le processeur 20, grâce au dispositif de lecture 31, il est judicieux d'effectuer ce rafraîchissement lorsque ce dispositif de lecture 31 n'est pas utilisé par le processeur 20, afin de ne pas ajouter de temps de latence. Supposons que le dispositif de lecture 31 soit libre à un cinquième instant t5 et à un sixième instant t6, ces deux instants précédant le quatrième instant t4. Si le rafraîchissement de la variable V1 est effectué au cinquième instant t5, la variable V1 ne sera plus exploitable à partir d'un septième instant t7, tel que t7-t5=Δt1, qui précède le deuxième instant t2. Un nouveau rafraîchissement de la variable V1 sera alors nécessaire avant le septième instant t7, ce qui augmentera notamment les temps de latence et la consommation de courant du processeur 20. Cette solution n'est donc pas judicieuse. Mais si le rafraîchissement de la variable V1 est effectué au sixième instant t6, la variable V1 ne sera plus exploitable à partir d'un huitième instant t8, tel que t8-t6=Δt1, qui suit le deuxième instant t2. Par conséquent, le deuxième processus P2 pourra utiliser la variable V1 au deuxième instant t2. Il est donc judicieux de rafraîchir la variable V1 à l'instant t6 où le dispositif de lecture 31 n'est pas utilisé par le processeur 20, et vérifiant les conditions :
- t6<t1+Δt1
- t6+Δt1>t2
Pour être utilisée par le deuxième processus P2, la variable V1 est lue au deuxième instant t2 par le processeur 20, c'est-à-dire qu'elle est rafraîchie à ce deuxième instant t2. Comme le temps de rétention Δt1 de la variable V1 est supérieur à l'écart existant entre le deuxième instant t2 et le troisième instant t3, le troisième processus P3 pourra utiliser la variable V1 au troisième instant t3 sans que cela ne nécessite de rafraîchissement entre le deuxième instant t2 et le troisième instant t3.

Si les trois processus décrits ci-dessus sont définis dans un programme, il est possible de connaître, lors de la compilation de ce programme, l'ordre et le chronométrage des processus, les variables intervenant dans ces processus, les temps de rétention de ces variables et les instants auxquels le dispositif de lecture 31 est utilisé. Il est alors possible de prévoir les instants auxquels ces variables doivent être rafraîchies, de manière à réduire les temps de latence. D'autre part, connaissant les instants auxquels toutes les variables intervenant dans le programme doivent être rafraîchies, il est possible de placer les variables de manière judicieuse dans la mémoire dynamique 21, afin de réduire les temps de latence. Ainsi, si l'on place sur une même ligne, par exemple, toutes les variables devant être rafraîchies à un même instant, le rafraîchissement de ces variables demandera moins de temps que si les variables en question sont réparties de manière aléatoire dans la mémoire dynamique 21. En effet, du fait que le processeur 20 ne doit alors générer qu'un seul signal 27a, le rafraîchissement de dix variables situées sur une même ligne demande dix fois moins de temps que le rafraîchissement de dix variables situées sur dix lignes différentes.

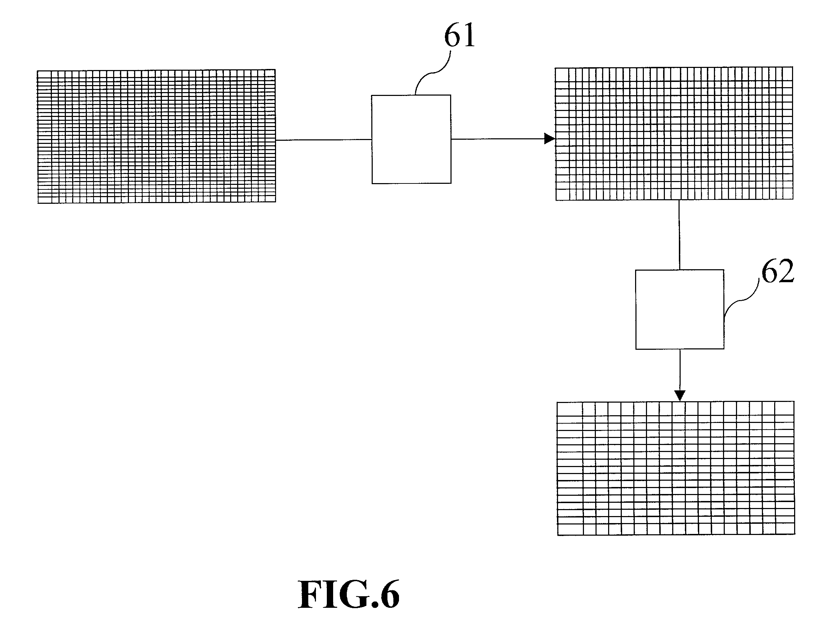

La figure 6 illustre une application de l'invention dans un système de traitement de données vidéo. Un tel système comprend un filtre vertical 61 et un filtre horizontal 62.

Il existe différents formats pour la diffusion de données vidéo. Par exemple, un standard de télévision numérique américaine ATSC définit dix huit formats de diffusion différents, comme le format standard où une image comprend 480 lignes de 720 pixels chacune, ou le format haute définition où une image comprend 1080 lignes de 1920 pixels chacune. Lorsque des données vidéo sont diffusées au format haute définition, il est nécessaire de les convertir au format standard pour pouvoir les visualiser sur une télévision dont l'écran n'est pas compatible avec le format haute définition. Le filtre vertical 61 et le filtre horizontal 62 permettent d'effectuer une telle conversion. Chaque ligne d'une image est stockée sous la forme d'une variable dans une mémoire dynamique appartenant au filtre vertical 61. Les opérations à effectuer sur ces lignes pour convertir 1080 lignes de 1920 pixels en 480 lignes de 1920 pixels constituent une partie d'un programme. Ce programme est complexe, mais l'ensemble des opérations est défini dès la compilation du programme, ce qui permet de mettre en oeuvre l'invention pour une telle conversion de format. Il en est de même pour un programme permettant au filtre 62 de convertir 480 lignes de 1920 pixels en 480 lignes de 720 pixels. Or, dans un tel système de traitement de données vidéo, il faut convertir environ 30 images par secondes d'un format vers un autre. Par conséquent, les différents procédés de rafraîchissement selon l'art antérieur ne permettaient pas d'utiliser de mémoire dynamique dans un tel système de traitement de données vidéo, car les temps de latence étaient trop importants. L'invention, en permettant de diminuer les temps de latence liés au rafraîchissement, permet d'utiliser des mémoires dynamiques, plutôt que des mémoires statiques, dans un tel système de traitement de données vidéo et, par conséquent, de réduire le coût d'un tel système.

La description ci-dessus en référence aux figures illustre l'invention plutôt qu'elle ne la limite. A cet égard, quelques remarques sont faites ci-dessous.

Les figures 1, 5 et 6 illustrent une application de l'invention, qui permet de réduire les temps de latence pour des systèmes où l'ensemble des opérations est connu dès la compilation d'un programme qui les définit. Il faut noter que l'invention procure d'autres avantages, telle la réduction de la consommation de courant, comme il est évoqué dans la description de la figure 5. De ce fait, il sera avantageux de mettre en oeuvre l'invention dans certains systèmes, même si les contraintes de temps réel ne sont pas importantes, c'est à dire même si la réduction du temps de latence n'est pas indispensable.

La figure 5 explique le principe de l'invention. Les programmes auxquels est destinée l'invention peuvent être plus complexes, c'est à dire faire intervenir un plus grand nombre de variables et de processus. Cependant, quelle que soit la complexité du programme, l'invention peut être mise en oeuvre, dès lors qu'il est possible de connaître l'ensemble des opérations effectuées par le programme lors de la compilation de celui-ci. A cet égard, la figure 6 n'est qu'un exemple de mise en oeuvre de l'invention et il est bien entendu possible d'appliquer l'invention à d'autres systèmes qu'un système de traitement de données vidéo.

En principe, il est possible d'implémenter le procédé selon l'invention au moyen d'un dispositif de traitement de données, par exemple un circuit intégré convenablement programmé. Un jeu d'instructions contenu dans une mémoire de programmation peut ordonner au circuit intégré d'effectuer les différentes étapes décrites précédemment. Le jeu d'instructions peut être chargé dans la mémoire de programmation par la lecture d'un support de données comme, par exemple, un disque sur lequel est codé le jeu d'instructions. La lecture peut s'effectuer par l'intermédiaire d'un réseau de communication comme, par exemple, l'Internet. Dans ce cas, un fournisseur de service mettra le jeu d'instructions à la disposition des intéressés. Un tel dispositif de traitement de données peut faire partie d'un équipement comprenant des moyens de stockage et de traitement de données. Le processeur 20 est un exemple d'un tel équipement.

## Revendications

1. Procédé de rafraîchissement d'une mémoire dynamique destinée à stocker des variables intervenant dans des opérations effectuées par un processeur, **caractérisé en ce qu'**il comprend :
- une étape d'ordonnancement au cours de laquelle sont établis un ordre et un chronométrage desdites opérations ;
- une étape d'estimation d'un temps de rétention propre à chaque variable ;
- une étape de prévision d'au moins un instant auquel chaque variable doit être rafraîchie, un instant auquel une variable donnée doit être rafraîchie étant fonction du temps de rétention de ladite variable donnée et du chronométrage des opérations dans lesquelles intervient ladite variable donnée ;
- une étape de placement au cours de laquelle lesdites variables sont placées dans ladite mémoire ;
- une étape de rafraîchissement au cours de laquelle lesdites variables sont rafraîchies aux instants définis pendant l'étape de prévision.

2. Procédé de rafraîchissement d'une mémoire dynamique selon la revendication 1, **caractérisé en ce que** lesdites étapes d'ordonnancement, d'estimation du temps de rétention de chaque variable, de placement et de prévision sont effectuées par le processeur, lors d'une compilation d'un programme définissant lesdites opérations.

3. Procédé de rafraîchissement d'une mémoire dynamique selon la revendication 1, **caractérisé en ce que** le rafraîchissement d'une variable est effectué par le processeur grâce à un dispositif de lecture de ladite variable.

4. Procédé de rafraîchissement d'une mémoire dynamique selon la revendication 3, **caractérisé en ce qu'**il comprend, en outre, une étape de planification des instants auxquels ledit dispositif de lecture est susceptible d'effectuer ladite étape de rafraîchissement, ladite étape de planification étant effectuée par le processeur, lors d'une compilation d'un programme définissant lesdites opérations.

5. Programme d'ordinateur comprenant des instructions de code de programme pour l'exécution des étapes du procédé selon la revendication 1 lorsque ledit programme est exécuté sur un ordinateur.

6. Equipement comprenant des moyens de stockage et de traitement de données, dont notamment des moyens de mise en oeuvre d'un procédé selon la revendication 1.
